# EUROPEAN PATENT APPLICATION

(11) **EP 4 366 164 A1**
(43) Date of publication of application: **08.05.2024**
(21) Application number: 22819206.8
(22) Date of filing: 16.04.2022
(51) Int. Cl.: H03F 17/00

(54) **OPTOELECTRONIC UNIT USE METHOD, AND AMPLIFICATION APPARATUS**

(30) Priority: 10.08.2021 CN 202110915354; 22.08.2021 CN 202110964472; 11.10.2021 CN 202111184128; 13.10.2021 CN 202111194542; 03.11.2021 CN 202111295534; 10.11.2021 CN 202111328342; 03.02.2022 CN 202210115090; 17.02.2022 CN 202210147507; 17.02.2022 CN 202210147515; 25.02.2022 CN 202210178707; 09.04.2022 WO PCT/CN2022/085989
(71) Applicant: SEMITRI PTY LTD, VIC, 3150 (AU)
(72) Inventor: GUO, Qiaoshi, Shilou Town, Panyu District Guangzhou, Guangdong 511447 (CN); ZHANG, Yixuan, Wheelers Hill VIC, 3150 (AU)
(74) Representative: Sun, Yiming
(86) International application number: PCT/CN2022/087245
(87) International publication number: WO 2022/257603

(57) **Abstract**

The present invention relates generally to a method of use for photoelectric unit and an amplification apparatus thereof, and more specifically, to a method using a photoelectric unit to provide bias for a device that is used for signal amplification, and an amplification apparatus with good performance. The photoelectric unit comprises a light-emitting element and a receiving element for the conversion of light energy into electrical energy, wherein the receiving element is an energy output element, and connected to a bias electrode of a device that is used for signal amplification. The present invention is reasonable in design, using the photoelectric unit to provide bias energy, and has the advantage of good performance.

## Description

### TECHNICAL FIELD

The present invention relates generally to a method of use for photoelectric unit and an amplification apparatus thereof, and more specifically, to a method using a photoelectric unit (photocell, photodiode) to provide bias for a device that is used for signal amplification, and an amplification apparatus with good performance.

### BACKGROUND

In the conventional amplification apparatuses, bias supplied to devices (such as BJTs, FETs, IGBTs, vacuum tubes, and other full-controlled devices) is provided by the power supply (or other power supplies) of the devices via bias circuits (resistors, etc.), in which the existing bias is easily affected by fluctuations of the power supply (such as interference, and in a push-pull amplification circuit, there may also be fluctuations of the ground potential difference between output devices), resulting in a problem of poor stability.

### SUMMARY

The object of the present invention is to solve the problem mentioned in background and provide a method using a photoelectric unit to provide bias for a device that is used for signal amplification, as well as an amplification apparatus with good performance.

The object of the present invention is achieved by the following technical solutions:
A method of use for a photoelectric unit wherein the photoelectric unit comprises a light-emitting element and a receiving element for the conversion of light energy into electrical energy, wherein the receiving element is an energy output element and connected to a bias electrode of a device that is used for signal amplification.

An amplification apparatus comprises a device and a photoelectric unit, wherein the device is connected to the photoelectric unit.

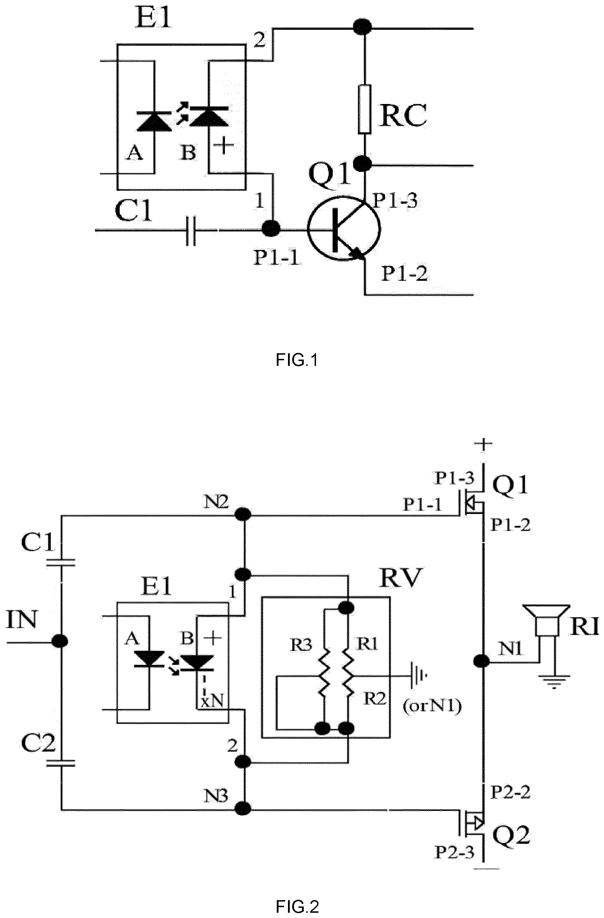

As shown in Figure 1, the apparatus comprises a device Q1 (a BJT; in a case where a voltage-controlled device is adopted, a resistor may be connected in parallel between a first electrode P1-1 and a second electrode P1-2 of the device) that is used for signal amplification, and a photoelectric unit E1 (formed by a light-emitting element A and a receiving element B). A receiving element B is connected to a bias electrode (a first electrode) of the device Q1. The light-emitting element A emits light to the receiving element B, making the device Q1 enter into active state. Figure 1 also shows that the receiving element B, through which the power supply provides bias current for the device Q1 (the current is depended on the counterpart generated by the receiving element B), is serially connected to the first electrode and used for current-limiting (as a constant current source). When a photoelectric unit E1 with higher open-circuit voltage is selected, it may be connected in parallel to the bias electrodes of the device Q1 (i.e., the first and second electrodes; in a case where a vacuum tube is adopted for the device Q1, the cathode of the photoelectric unit E1 is connected to the gate of the vacuum tube). The output current (voltage) of the photoelectric unit E1, which acts as an energy source, is determined by the light-emitting element A. A capacitor C1 (a coupling element) that is connected to the first electrode is used for signal input. A resistor RC may be selected in accordance with requirements.

The present invention is reasonable in design, which provides bias energy in the advantage of a photoelectric unit, and has the advantage of good performance.

### BRIEF DESCRIPTION OF THE DRAWINGS

FIG. 1 is a schematic diagram of a method of use for photoelectric unit and an amplification apparatus thereof of the present invention.
FIG. 2 is schematic diagram 1 of embodiment 1 of a method of use for photoelectric unit and an amplification apparatus thereof of the present invention.
FIG. 3 is schematic diagram 2 of embodiment 1 of a method of use for photoelectric unit and an amplification apparatus thereof of the present invention.
FIG. 4 is schematic diagram 3 of embodiment 1 of a method of use for photoelectric unit and an amplification apparatus thereof of the present invention.
FIG. 5 is schematic diagram 4 of embodiment 1 of a method of use for photoelectric unit and an amplification apparatus thereof of the present invention.
FIG. 6 is schematic diagram 1 of embodiment 2 of a method of use for photoelectric unit and an amplification apparatus thereof of the present invention.
FIG. 7 is schematic diagram 2 of embodiment 2 of a method of use for photoelectric unit and an amplification apparatus thereof of the present invention.
FIG. 8 is schematic diagram 3 of embodiment 2 of a method of use for photoelectric unit and an amplification apparatus thereof of the present invention.
FIG. 9 is schematic diagram 4 of embodiment 2 of a method of use for photoelectric unit and an amplification apparatus thereof of the present invention.
FIG. 10 is a schematic diagram of embodiment 3 of a method of use for photoelectric unit and an amplification apparatus thereof of the present invention.
FIG. 11 is schematic circuit diagram 1 of devices of a method of use for photoelectric unit and an amplification apparatus thereof of the present invention.
FIG. 12 is schematic circuit diagram 2 of devices of a method of use for photoelectric unit and an amplification apparatus thereof of the present invention.

### DETAILED DESCRIPTION

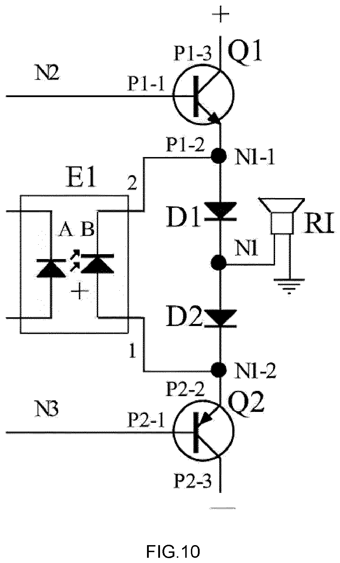

Embodiments of the method of use for photoelectric unit and the amplification apparatus thereof of the present invention are shown in FIG. 2, FIG. 3, FIG. 4, FIG. 5, FIG. 6, FIG. 7, FIG. 8, FIG. 9, and FIG. 10. The photoelectric unit E1 (a first photoelectric unit; or E2, a second photoelectric unit) includes a light-emitting element A and a receiving element B for the conversion of light energy into electrical energy. The receiving element B is an energy output element and connected to the bias electrodes (the first electrode, or second electrode) of the devices for signal amplification (a device Q1 and a device Q2, defined as a first device and a second device respectively; a push-pull amplification circuit is formed by the devices Q1 and Q2). The first electrodes of the devices (Q1, Q2) are used for the signal input (the signal is not provided by the photoelectric unit). The receiving element B provides bias to the devices (Q1, Q2), making them operate in the active region. The amplification apparatus comprises the devices (Q1, Q2) and the photoelectric unit E1 (or E2). The photoelectric unit E1 (or E2 with the receiving element B thereof) is connected to the first electrode of the device Q1 and the counterpart of the device Q2 (note that FIG.10 shows that the photoelectric unit E1 is connected to the second electrode of the device Q1 and the counterpart of the device Q2).

Embodiment 1 of a method of use for photoelectric unit and an amplification apparatus thereof of the present disclosure is shown in FIG. 2, FIG. 3, FIG. 4, and FIG. 5. An amplification apparatus further includes a capacitor C1 and a capacitor C2. The capacitor C1 is connected to the first electrode of the device Q1, and the capacitor C2 is connected to that of the device Q2. The node N1 at which the second electrode of the device Q1 and the counterpart of the device Q2 are connected is used for signal output.

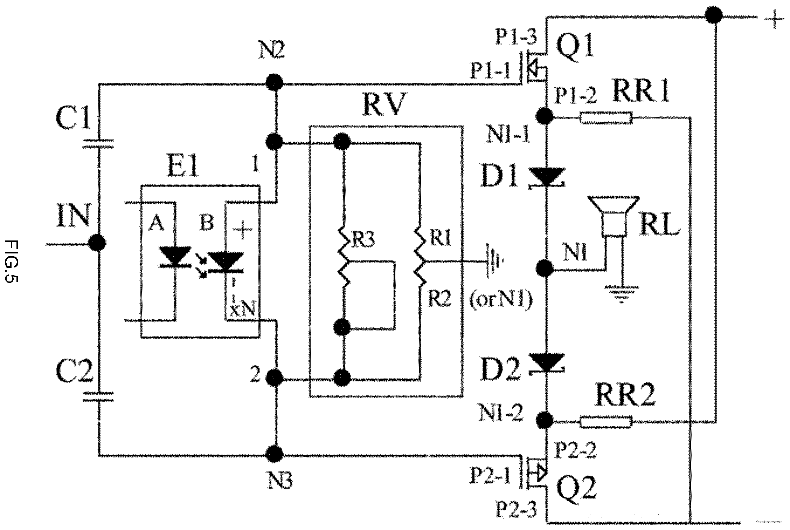

As shown in FIG. 2, FIG. 3 and FIG. 5, an RV (a discharge element) used for voltage-limiting (electric charge discharging) is connected to the photoelectric unit E1 (the receiving element B), and a parallel circuit is formed by the discharge element RV and the photoelectric unit E1. The two ends of the parallel circuit are connected to the two first electrodes (P1-1, P2-1), respectively. RV is serially formed by a resistor R1 and a resistor R2, which have a common node connected to ground (or N1). The resistors R1 and R2 are used to adjust the ground potential difference of the common node N1. For the convenience of regulating the quiescent current of the devices (Q1, Q2), the discharge element RV includes a third discharge element R3 (a third resistor that may be adopted as an adjustable resistor, or a series diode circuit, or a fixed resistor). It is noted that the discharge element RV is adopted in accordance with requirements (note that among the resistors R1 and R2 and the third discharge element R3, one of, or two of them may be selected). The resistance values of the resistors R1 and R2 may be selected in a range between 1 MΩ and 10 MΩ. When the photoelectric unit (the receiving element B) and the discharge element together form a parallel circuit, such circuit can form a constant voltage source in order to limit the output voltage of the photoelectric unit E1 whereby the devices can operate in the active region. FiG.5 shows an amplification apparatus which makes it achievable to prevent devices Q1 and Q2 from cutoff state during their operation, and further includes a diode D1, a diode D2, a first current-limiting element RR1, and a second current-limiting element RR2, wherein the diode D1 is connected to the second electrode of the device Q1, and the diode D2 is connected to that of the device Q2. The device Q1, the diode D1, the diode D2, and the device Q2 form a series circuit. The common node of the diodes D1 and D2 is used for signal output. The common node N1-1 of the device Q1 and diode D1, and the common node N1-2 of the diode D2 and device Q2 are connected to the power supply (which is between the two ends of the push-pull amplification circuit formed by the devices Q1 and Q2) via the first current-limiting element RR1 and second current-limiting element RR2, respectively. The present circuit overcomes the distortion caused by the cutoff state of the diode D1 (D2) in the advantage of photoelectric unit E1. The power supply injects current to the node N1-1 (N1-2) via the first current-limiting element RR1 (the second current-limiting element RR2), biasing the second electrode of the device Q1 (Q2) in order to make it achievable to prevent cutoff state during the operation, which has the advantages of simple circuitry and high stability.

Operating principle: as the light-emitting element A of the photoelectric unit E1 as well as the two ends of the devices Q1 and Q2 power on, the devices Q1 and Q2 obtain bias voltage, subsequently entering into the active region.

In this embodiment, the quiescent current flowing through the devices (Q1 and Q2) can be adjusted by the regulation of the drive current of the light-emitting element A, in addition, in accordance with the load RL's (or the devices') current, it can realize a smart bias by automatically (adaptively) adjusting the current flowing through the devices (Q1 and Q2) in the advantage of a control circuit which regulates the light-emitting element A.

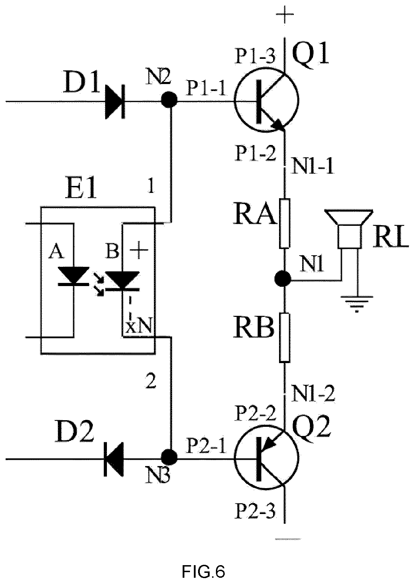

Embodiment 2 of a method of use for photoelectric unit and an amplification apparatus thereof of the present disclosure is shown in FiG.6, FiG.7, FiG.8 and FiG.9. An amplification apparatus (output circuit) is an amplification apparatus that makes it prevent the devices from cutoff state, further including a diode D1 and a diode D2. The diode D1 is connected to the first electrode of the device Q1, and diode D2 is connected to that of the device Q2. The diodes D1 and D2 are used for the signal input.

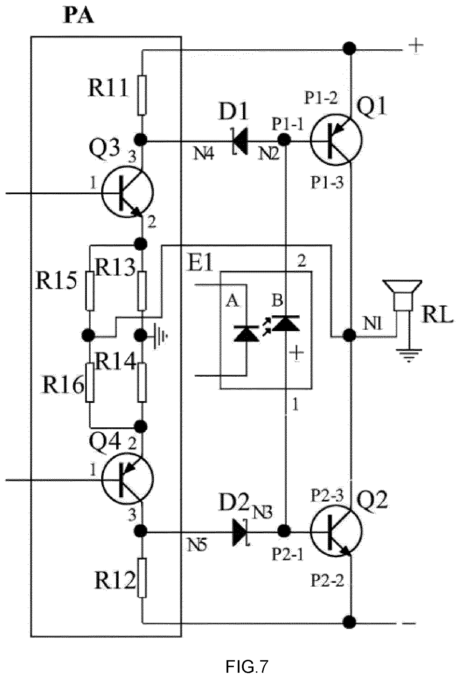

As shown in Figure 7, it is an amplification apparatus (output circuit) that uses a third electrode(s) (P1-3, P2-3) of the devices (for power output) as an output electrode. The second electrode of the device Q1, the third electrode of the device Q1, the third electrode of the device Q2, and the second electrode of the device Q2 are connected in series to form a first series circuit; the second electrode of the device Q1, the first electrode of the device Q1, the photoelectric unit E1, the first electrode of the device Q2, and the second electrode of the device Q2 are connected in series to form a second series circuit. The two ends of the first and second series circuits are used to connect the power supply. When voltage-controlled devices are selected for the devices, a resistor should be connected in parallel between the first and second electrodes (not shown). The photoelectric unit E1 and bias electrodes (the first electrodes) of the devices are connected in series for current limiting, in order to realize a bias to the devices. Photocells (photodiodes) whose output voltage is insufficient to have the devices driven to turn on may be selected, having the advantages of low cost and simple circuitry (note that for better understanding, there is a driver stage PA added to FIG.7, while driver stages of different circuit types may also be selected).

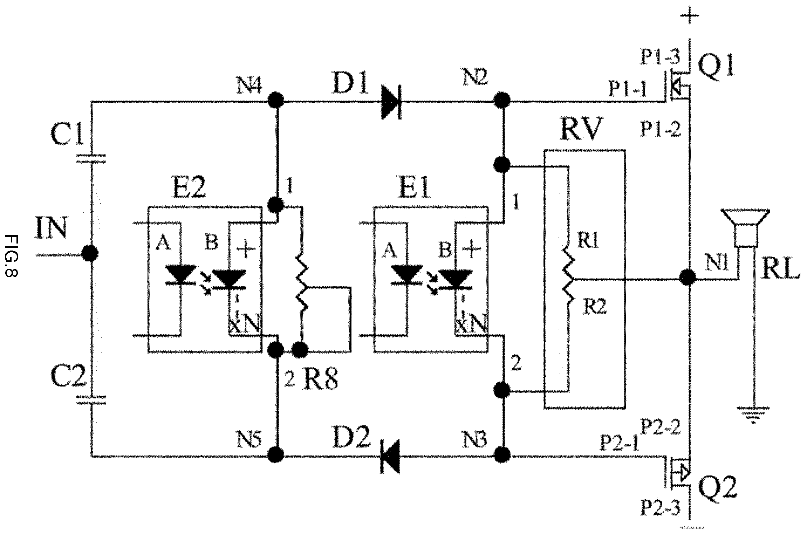

FIG.8 shows a second photoelectric unit E2, a discharge element(s) (resistors R1 and R2) which is connected to the first photoelectric unit E1, a capacitor C1, a capacitor C2, a discharge element R8 (the eighth resistor; other elements such as diodes, etc., may also be adopted). A series circuit formed by the resistors R1 and R2 is connected in parallel to the first photoelectric unit E1 (the receiving element B). The common node of the resistors R1 and R2 is connected to the common node N1 of the devices Q1 and Q2, and the common node N1 at which the second electrode of the device Q1 and the counterpart of the device Q2 are connected is used for signal output. The capacitor C1 is connected to the first electrode of the device Q1 via diode D1, and the capacitor C2 is connected to the first electrode of the device Q2 via diode D2. The two ends of the second photoelectric unit E2 are connected to the first electrode of the device Q1 and the counterpart of the device Q2 via the diode D1 and diode D2, respectively. The second photoelectric unit E2 is connected in parallel to the discharge element R8.

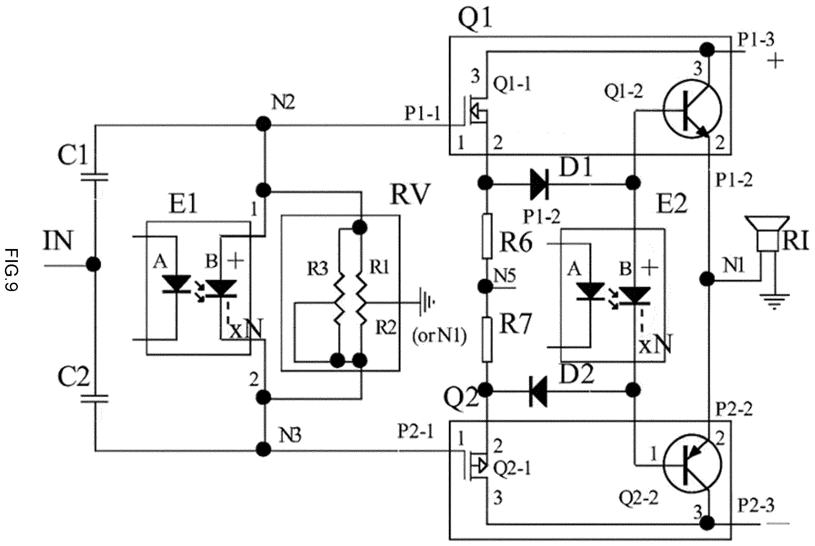

As shown in Figure 9, the apparatus includes capacitors C1 and C2. The device Q1 comprises Q1-1, a first one of the device Q1, and Q1-2, a second one of the device Q1; the device Q2 comprises Q2-1, a first one of the device Q2, and Q2-2, a second one of the device Q2. Q1-1 is connected to the first electrode of Q1-2 via the diode D1, and Q2-1 is connected to that of Q2-2 via the diode D2. The first photoelectric unit E1 is connected to the discharge element RV, furthermore to the first electrode of Q1-1 and the counterpart of Q2-1; the second photoelectric unit E2 is connected to the first electrode of Q1-2 and the counterpart of Q2-2. The common node N1 at which the second electrode of Q1-2 and the counterpart of Q2-2 is connected is used for signal output. C1 is connected to the first electrode of Q1-1, and C2 is connected to that of Q2-1.

Operating principle: When the input signal is of high amplitude, whichever of the diodes D1 and D2 turns off, the photoelectric unit E1 (or E2 as shown in FIG. 9) makes the devices (Q1 and Q2, or Q1-2 and Q2-2 as shown in FIG. 9) maintain in the active state, overcome a variety of problems caused by the occurrences of cutoff state (e.g., switching distortion, crossover distortion, high-frequency characteristics degradation, etc.). The diodes D1 and D2 input DC bias signals (the bias is provided by PA in FIG.7, E2 in FIG.8, and E1 in FIG.9, which can overcome the crossover distortion caused by the diodes D1 and D2). When the amplification apparatus (used for digital audio amplification, for example, as pulse signals may also be defined as AC signals) omits the distortion caused by the diodes, it only needs to connect the diode D1 and diode D2 to each other, the common node of which is used for signal input.

In this embodiment, when there is more than one photoelectric unit or receiving element thereof, the first one of the photoelectric units (or the receiving element thereof) may be connected in parallel to the diode D1, and the second one of the photoelectric units (or the receiving element thereof) may be connected in parallel to the diode D2, which realizes high-dynamic class A (class HA) amplification.

Embodiment 3 of a method of use for photoelectric unit and an amplification apparatus thereof of the present disclosure is shown in Figure 10. An amplification apparatus (output circuit) is an amplification apparatus that makes it prevent the devices from cutoff state, further includes a diode D1 and a diode D2. The diode D1 is connected to the second electrode of the device Q1, and the diode D2 is connected to that of the device Q2. The device Q1, the diode D1, the diode D2, and the device Q2 together form a series circuit; the common node of the diodes D1 and D2 is used for signal output; the series circuit formed by the diodes D1 and D2 is connected in parallel to the receiving element B of the photoelectric unit E1, in addition, the diode D1 and diode D2 may be individually connected to a receiving element B (the first one of the receiving element B and the second one of the receiving element B). The present circuit may be used in conjunction with relevant circuits revealed above, wherein the first electrode of the device may be connected to a ground resistor.

Operating principle: when the input signal is of high amplitude, whichever of the diodes D1 and D2 turns off, the current generated by the photoelectric unit E1 makes the devices Q1 and Q2 maintain in the conductive state, overcome a plurality of problems (e.g., switching distortion, crossover distortion, high-frequency characteristics degradation, etc.) caused by the occurrences of cutoff state.

In the foregoing embodiments, in order to improve operating stability, a resistor may be connected in series to the first electrode, and the same to the second electrode.

In the foregoing embodiments, when the load RL is not grounded, relevant circuits may be added, additionally, it may also be applied to a bridging power-amplification circuitry. One of the devices Q1 and Q2 is N-type, the other is P-type (may also select a formation in which a P-type device is driving a N-type device).

In the foregoing embodiments, the diode (D1 or D2) is preferably a Schottky diode, or a switching diode, or a fast recovery diode.

Definitions of the foregoing embodiments:
The device Q1 and device Q2 are defined as the first device and second device, respectively;

C1 and C2 are coupling elements that are connected to the first electrodes of the devices, and defined as the first coupling element and second coupling element, respectively; signals to be amplified are connected to the first electrodes via the coupling elements. If the first and second coupling elements adopt diodes in placement of capacitors, there may be one or more than one series diode circuit to be used to replace the capacitors, in such case, the diode may also be used as a discharge element for the photoelectric unit; when C1 and C2 are omitted, diodes D1 and D2 may also be defined as the first coupling element and second coupling element, respectively.

The resistor R1 and resistor R2 are defined as the first resistor and second resistor respectively and preferably selected as an adjustable resistor.

The diode D1 and diode D2 are defined as the first diode and second diode respectively; with the use of the diodes D1 and D2, class HA amplification can be realized.

The first electrode is base (the first electrode of current-controlled devices) or gate (the first electrode of voltage-controlled devices); the second electrode is emitter, or source, or cathode; the third electrode is collector, or drain, or anode.

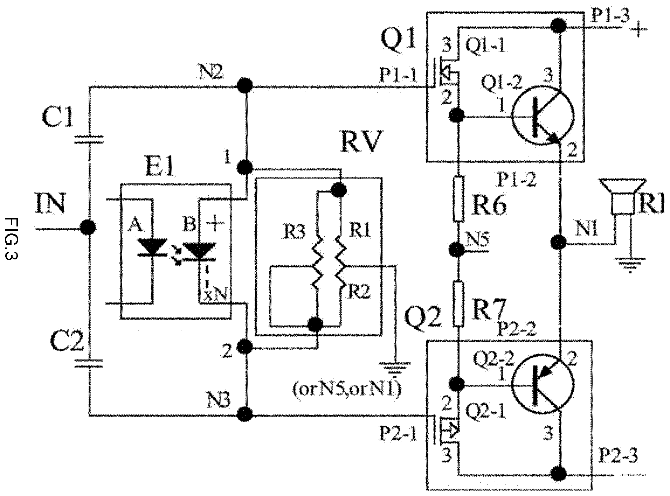

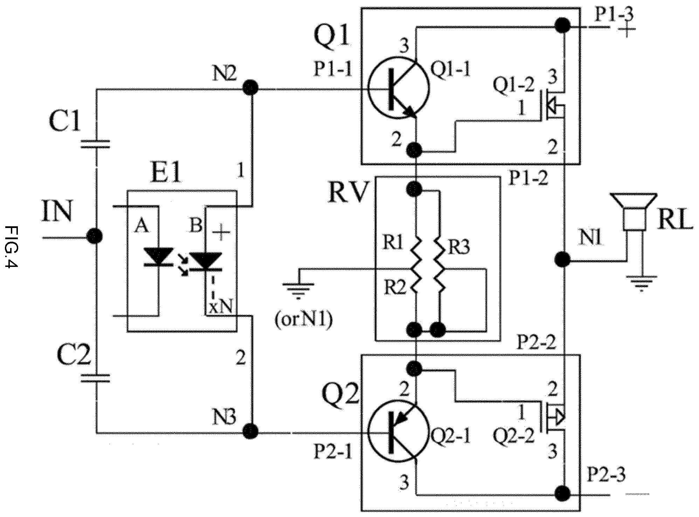

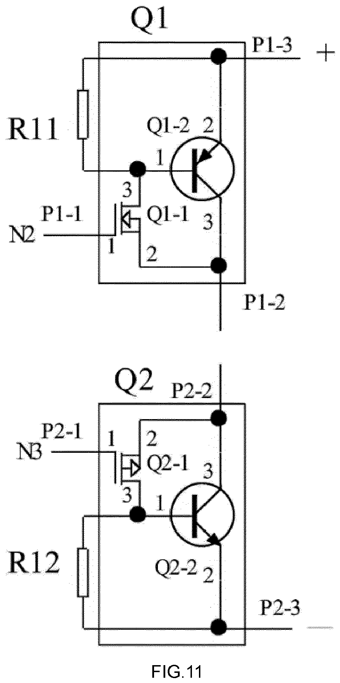

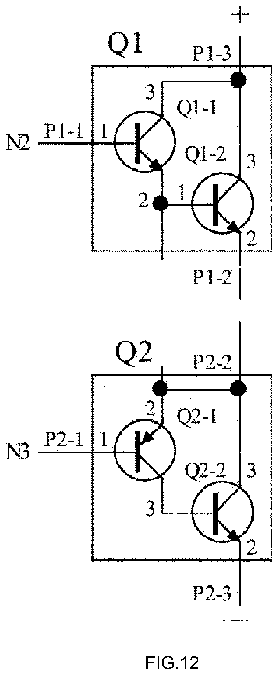

As shown in FIG.1, FIG.2, FIG.5, FIG.6, FIG.7, FIG.8, and FIG.10, Q1 (or Q2, optionally) is a single-stage amplification unit using a FET, BJT, or IGBT, or a Darlington device, or other equivalent devices (as shown in FIG. 11 and FIG. 12, the FET in FIG. 11 may be a BJT instead, whereby may reduce the required number of photodiodes of the receiving element B). Q1 and Q2 in FIG. 3 and FIG.4 are formed by a FET and a BJT (a FET driving a BJT, which is equivalent to a FET; Q1 and Q2 in FIG. 4 are a BJT driving a FET, which is equivalent to a BJT), and may also be formed by two FETs (a FET driving a FET, equivalent to a FET), or two BJTs. The specific types of Q1 and Q2 in the foregoing embodiments may be selected in accordance with requirements and may interchange flexibly.

The schematic diagrams shown in FIG. 6, FIG. 7 and FIG. 10 are suitable for a combination of various driver stage circuits, and the diagrams comprising the first and second coupling elements are especially suitable to be used for a (loop-free negative-feedback) 0DB power amplifier, which has the advantages of high input impedance (convenient for matching a plurality of voltage driver stages, such as vacuum tube driver stages) and good frequency characteristics, which is especially suitable for audio signal amplification within a bandwidth in a range between 20HZ and 20kHZ and it has overcome or reduced the attenuation to low-frequency signals caused by the capacitors used for coupling (e.g., when capacitors are selected for the first and second coupling elements).

The photoelectric unit is convenient to isolate the quiescent current of the auto-adjusting devices to realize the regulation of operational modes among class A, class AB or class B, in addition, it can also be used for dynamic class A regulation. The two ends of the photoelectric unit are connected to the two first (or second) electrodes of the devices respectively. Balanced regulation of the quiescent current of the devices can be achieved by adjusting the drive current flowing through the light-emitting element of the photoelectric unit. The node N1 has a good stability of quiescent ground potential difference. A photoelectric coupler (remarkably small at size and is an energy output element) may be selected for the photoelectric unit, which may be used singly or plurally, in series or in parallel or in a combination thereof; it is also applicable to use a plurality of LEDs connected in series (or in parallel, or in a combination thereof) to form the light-emitting element, and to use a plurality of photodiodes (photocells) connected in series (or in parallel, or in a combination thereof) to form the receiving element. The light-emitting element together with the receiving element are packaged as a module for the convenience of batch use. When the photoelectric unit (the receiving element thereof) is serially connected in a circuit as a constant-current source to realize constant current, it may be formed by a selected photocell (photodiode) with an output voltage of about 0.4V in conjunction with a light-emitting element. The light-emitting element of the photoelectric unit is preferably an LED, and the receiving element preferably a photocell (photodiode). By adjusting the drive current flowing through the light-emitting element, it is capable of adjusting the output current of the receiving element.

When it is used for non-push-pull amplification, the relevant devices and elements may be omitted on the basis of the foregoing embodiments, it can be used as highspeed pulse amplification or single-device full-wave amplification with the same operating principles.

Biasing the devices with the current generated from the photoelectric unit (when biasing voltage-controlled devices such as FETs, the current-to-voltage conversion is achieved by the use of a discharge element - note that the receiving element B has current-source characteristics) has the advantage of simple circuitry, in addition, it is capable for the bias as well as the static ground potential difference of node N1 to be independent of the power supply of the device(s), having low interference introduced by the bias.

The method of use for the photoelectric unit of the present invention is especially suitable for biasing power (audio) amplification device(s), and it has overcome the instability of conventional amplification apparatuses. The photoelectric unit claiming the same method of use as the present invention revealed above also lies within the scope of protection of the present invention.

The present invention is reasonable in design and has the advantages of simple circuitry and good performance (e.g., stability, signal-to-noise ratio, etc.).

## Claims

1. A method of use for a photoelectric unit, wherein the photoelectric unit comprises a light-emitting element and a receiving element for the conversion of light energy into electrical energy, wherein the receiving element is an energy output element and connected to a bias electrode of a device that is used for signal amplification.

2. A method of use for a photoelectric unit according to claim 1, wherein a first electrode of the device is used to input the signal, and the receiving element provides the device with bias, whereby the device operates in the active region, while the signal is not provided by the photoelectric unit.

3. An amplification apparatus based on the method of use for the photoelectric unit in claim 1 or claim 2, wherein the apparatus comprises the device and the photoelectric unit, wherein the device is connected to the photoelectric unit.

4. The amplification apparatus according to claim 3, wherein the receiving element is a photodiode.

5. The amplification apparatus according to claim 3, wherein the photoelectric unit is a photocoupler.

6. The amplification apparatus according to claim 3, wherein the receiving element, as an energy source, is connected in parallel to the bias electrode of the device.

7. The amplification apparatus according to claim 3, wherein the receiving element is connected in series to the first electrode of the device and used for constant current.

8. The amplification apparatus according to claim 3, wherein the receiving element is connected to the first electrode of the device.

9. The amplification apparatus according to claim 8, further comprising a discharge element, wherein the receiving element is connected to the discharge element.

10. The amplification apparatus according to claim 8, further comprising a coupling element, wherein the signal is connected to the first electrode through the coupling element.

11. The amplification apparatus according to claim 10, wherein the coupling element is a diode, which is connected in parallel to the receiving element.

12. The amplification apparatus according to claim 3, further comprising a diode, wherein the diode is connected in series to a second electrode of the device and connected in parallel to the receiving element.

13. The amplification apparatus according to claim 8, wherein the devices comprise a first device and a second device, which together form a push-pull amplification circuit; the receiving element is connected to a first electrode of the first device and a first electrode of the second device.

14. The amplification apparatus according to claim 13, further comprising a first coupling element and a second coupling element, wherein the first coupling element is connected to the first electrode of the first device, and the second coupling element is connected to the first electrode of the second device; the first and second coupling elements are used to input the signal.

15. The amplification apparatus according to claim 13, wherein a common node of a second electrode of the first device and a second electrode of the second device is used for signal output.

16. The amplification apparatus according to claim 13, further comprising a discharge element, wherein the receiving element and the discharge element form a parallel circuit.

17. The amplification apparatus according to claim 16, wherein the discharge element is formed by a first resistor and a second resistor that are connected in series, a common node of the first and second resistors is connected to ground, or to a common node of the first and second devices.

18. The amplification apparatus according to claim 17, wherein the discharge element further comprises a third discharge element, which is connected in parallel to the receiving element.

19. The amplification apparatus according to claim 13, further comprising a first diode and a second diode, wherein the first diode is connected to the first electrode of the first device, and the second diode is connected to the first electrode of the second device; the first and second diodes are used to input the signal.

20. The amplification apparatus according to claim 19, wherein the photoelectric unit comprises a first photoelectric unit, the two ends of which are connected to the two first electrodes respectively.

21. The amplification apparatus according to claim 20, further comprising a first resistor and a second resistor, wherein a series circuit formed by the first and second resistors is connected in parallel to the first photoelectric unit; a common node of the first and second resistors is connected to the counterpart of the first and second devices.

22. The amplification apparatus according to claim 20, further comprising a second photoelectric unit, a first coupling element, and a second coupling element, wherein the first coupling element is connected to the first electrode of the first device via the first diode, the second coupling element is connected to the first electrode of the second device via the second diode; the first and the second coupling elements are used to input the signal; the second photoelectric unit is connected to the first electrode of the first device and the counterpart of the second device via the first and second diodes respectively.

23. The amplification apparatus according to claim 22, wherein the second photoelectric unit is connected in parallel to a discharge element.

24. The amplification apparatus according to claim 19, wherein the first diode is connected to the second diode; the first and second diodes are used to input the signal.

25. The amplification apparatus according to claim 19, wherein the second electrode of the first device, a third electrode of the first device, a third electrode of the second device, and the second electrode of the second device are connected in series to form a first series circuit; the first diode is connected to the first electrode of the first device, and the second diode is connected to the first electrode of the second device; the first and second diodes are used for signal input; the first electrode of the first device and the counterpart of the second device are connected to the receiving element.

26. The amplification apparatus according to claim 25, wherein the second electrode of the first device, the first electrode of the first device, the receiving element, the first electrode of the second device, and the second electrode of the second device are connected in series to form a second series circuit; the two ends of the first and second series circuits are used to connect a power supply.

27. The amplification apparatus according to claim 25, wherein a resistor is connected in parallel between the first and second electrodes.

28. The amplification apparatus according to claim 13, further comprising a first coupling element, a second coupling element, a first diode, and a second diode, wherein the photoelectric unit comprises a first photoelectric unit and a second photoelectric unit; the first device comprises a first one of the first device and a second one of the first device, and the second device comprises a first one of the second device and a second one of the second device; the first one of the first device is connected to a first electrode of the second one of the first device via the first diode, and the first one of the second device is connected to a first electrode of the second one of the second device via the second diode; the first photoelectric unit is connected to a discharge element, the first electrode of the first one of the first device and the counterpart of the first one of the second device; the second photoelectric unit is connected to the first electrode of the second one of the first device and the counterpart of the second one of the second device; a common node of the second electrode of the second one of the first device and the counterpart of the second one of the second device is used for signal output; the first coupling element is connected to the first electrode of the first one of the first device, and the second coupling element is connected to the first electrode of the first one of the second device.

29. The amplification apparatus according to claim 13, further comprising a first diode, a second diode, a first current-limiting element, and a second current-limiting element, wherein the first diode is connected to the second electrode of the first device, and the second diode is connected to the second electrode of the second device; the first device, the first diode, the second diode, and the second device together form a series circuit; a common node of the first diode and the second diode is used for signal output; a common node of the first device and the first diode, and a common node of the second device and the second diode are connected to a power supply via the first current-limiting element and the second current-limiting element respectively.

30. The amplification apparatus according to claim 3, further comprising a first diode and a second diode, wherein the device comprises a first device and a second device, which form a push-pull amplification circuit, wherein the first diode is connected to the second electrode of the first device, and the second diode is connected to the second electrode of the second device; the first device, the first diode, the second diode, and the second device form a series circuit; a common node of the first and second diodes is used for signal output; the series circuit formed by the first diode and the second diode is connected in parallel to the receiving element.
